## Europäisches Patentamt
## European Patent Office
## Office européen des brevets

(19)

(11) Veröffentlichungsnummer: **0 120 260**
A2

(12) ## EUROPÄISCHE PATENTANMELDUNG

(21) Anmeldenummer: 84101516.7

(22) Anmeldetag: 14.02.84

(51) Int. Cl.³: **H 01 L 43/06**
**H 01 L 43/10**

(30) Priorität: 18.02.83 DE 3305628
28.06.83 DE 3323197

(43) Veröffentlichungstag der Anmeldung:
03.10.84 Patentblatt 84/40

(84) Benannte Vertragsstaaten:
DE FR GB

(71) Anmelder: International Standard Electric Corporation
320 Park Avenue
New York New York 10022(US)

(84) Benannte Vertragsstaaten:
FR GB

(71) Anmelder: Standard Elektrik Lorenz Aktiengesellschaft
Hellmuth-Hirth-Strasse 42
D-7000 Stuttgart 40(DE)

(84) Benannte Vertragsstaaten:
DE

(72) Erfinder: Hoffmann, Horst, Prof. Dr.
Ahornstrasse 7
D-8401 Pentling(DE)

(72) Erfinder: Dorn, Reimund, Dr.
Peter-von-Koblenz-Strasse 31
D-7141 Schwieberdingen(DE)

(72) Erfinder: Kersten, Peter, Dr.
Neuköllner Strasse 8
D-7250 Leonberg(DE)

(72) Erfinder: Gassmann, Gerhard G.
Thomasäckerweg 5
D-7300 Esslingen(DE)

(72) Erfinder: Müller, Siegfried, Dr.
Pfeiferstrasse 19
D-7440 Nürtingen(DE)

(74) Vertreter: Pohl, Heribert, Dipl.-Ing et al,
Standard Elektrik Lorenz AG Patent- und Lizenzwesen
Kurze Strasse 8 Postfach 300 929
D-7000 Stuttgart 30(DE)

(54) **Magnetfeldsensor und einen Magnetfeldsensor enthaltender Positionssensor.**

(57) Es sind bereits Magnetfeldsensoren bekannt, die den "planaren Halleffekt" ausnutzen. Es wird nun vorgeschlagen, solche Magnetfeldsensoren unter Verwendung ferromagnetischer amorpher Metalle herzustellen. Amorphe Metalle aus $Co_{75}Fe_5B_{20}$ oder $Co_{80}B_{20}$ sind hierfür besonders geeignet. Die Empfindlichkeit solcher Magnetfeldsensoren ist deutlich höher als bei herkömmlichen, meist unter Verwendung von Permalloy hergestellten Magnetfeldsensoren.

Mit solchen besonders empfindlichen Magnetfeldsensoren ist es auch möglich, neuartige Positionssensoranordnungen aufzubauen. Beispiele hierfür sind angegeben.

Fig.2

Croydon Printing Company Ltd.

H.Hoffmann I - R.Dorn - P.Kersten -
G.G.Gassmann - S.Müller 1-9-5-114X-4X

Magnetfeldsensor und einen Magnetfeldsensor
enthaltender Positionssensor

Die Erfindung betrifft einen Magnetfeldsensor nach dem
Oberbegriff des Hauptanspruchs und einen Positionssensor,
der mit einem solchen Magnetfeldsensor ausgestattet ist.

Es ist bereits seit langem bekannt und auch in der Technik
üblich, den Halleffekt zur Messung von Magnetfeldern auszunutzen. Fließt durch einen elektrisch leitfähigen Körper ein elektrischer Strom und wird dieser Körper gleichzeitig von einem Magnetfeld durchsetzt, das senkrecht
auf der Richtung des elektrischen Stroms steht, so bildet sich senkrecht zu diesen beiden Richtungen eine Feldstärke aus, die an der Oberfläche des Körpers als Spannung
abgegriffen werden kann. Weist dieser Körper eine magnetische Anisotropie auf, deren Vorzugsrichtung mit der
Stromrichtung zusammenfällt, so ergibt sich zusätzlich
eine elektrische Feldstärke, deren Richtung in einer durch
das Magnetfeld und die Stromrichtung vorgegebenen Ebene
liegt. Dieser Effekt wird als ebener oder planarer Halleffekt bezeichnet.

ZT/P2-Bs/Gn
24.06.1983

H.Hoffmann I 1-9-5-114X-4X

Ein Magnetfeldsensor, der diesen Effekt ausnützt, besteht beispielsweise aus einer kreisförmigen Blechscheibe, die eine magnetische Anisotropie aufweist, deren Vorzugsrichtung in der Fläche des Blechs liegt und die gleichmäßig an ihrem Umfang verteilt vier Anschlüsse aufweist, durch die zwei sich kreuzende Stromwege gebildet werden, von denen einer parallel zur Vorzugsrichtung der magnetischen Anisotropie liegt. Es ist auch schon bekannt, derartige Magnetfeldsensoren in Dünnschichttechnologie aufzubauen, beispielsweise durch die Veröffentlichung von V.D. Ky "Planar Hall Effect in Ferromagnetic Films" in der Zeitschrift Phys.Stat.Sol. Band 26 Seite 565 (1968). Derartige Magnetfeldsensoren sind sehr gut geeignet für die Messung kleiner, insbesondere auch räumlich begrenzter Magnetfelder. Die Empfindlichkeit ist etwa proportional zur Koerzitivfeldstärke und damit nach unten begrenzt. Die bekannten Sensoren verwenden Metallegierungen, vorzugsweise aus Nickel, Eisen und Kobalt. Die kleinste damit erreichbare Koerzitivfeldstärke liegt bei etwa 100 mA/cm.

Bei einem von einem Magnetfeld durchsetzten Leiter entsteht nicht nur eine Hallspannung, es ändert sich vielmehr auch der elektrische Widerstand dieses Leiters. Auch dieser Effekt kann ausgenützt werden, um eine Magnetfeldstärke zu bestimmen. Bei der Messung kleiner Magnetfelder auf diese Weise macht es sich jedoch störend bemerkbar, daß sich der Widerstand eines Leiters auch durch andere Einflüsse, vorzugsweise durch Temperaturänderungen, ändert.

Der Erfindung liegt die Aufgabe zugrunde, einen Magnetfeldsensor anzugeben, mit dem auch sehr kleine Magnetfelder bestimmt werden können.

H.Hoffmann I 1-9-5-114X-4X

Fig. 6    zeigt drei verschiedene Ansichten des Positionssensors gemäß Fig.5.

Fig. 7    zeigt die Zuordnung von Blende und Signal beim
         Positionssensor gemäß Fig. 5.

Ein Magnetfeldsensor, der den planaren Halleffekt ausnützt, ist um so empfindlicher, je kleiner das ihm eingeprägte magnetische Anisotropiefeld ist. Die kleinstmögliche
Anisotropiefeldstärke ist gleich der Koerzitivfeldstärke
des Materials. Ferromagnetische amorphe Metalle können so
hergestellt werden, daß ihre Koerzitivfeldstärke kleiner
als etwa 100 mA/cm beträgt. Dies ist der kleinste erreichbare Wert der Koerzitivfeldstärke kristalliner Metallegierungen. Amorphe Metalle werden vorwiegend in Form von dünnen Bändern (bis zu 100 μm Dicke),aus denen kleine Blechscheiben ausgestanzt werden können, oder als dünne Schichten (bis zu 5 μm Dicke) hergestellt. Die dünnen Schichten
können durch Aufdampfen oder Kathodenzerstäuben hergestellt werden.

Für Magnetfeldsensoren geeignet sind amorphe Metalle aus
einer Legierung, die auf Übergangselementen der Eisen-
Gruppe basiert. Weiter kann das amorphe Metall Metalloide
aus der Gruppe B, C, Si, Ge, P enthalten. Auch können Übergangsmetalle aus der Gruppe Ti, Zr, Hf, Nb enthalten sein.
Bis zu fünf Prozent (Atomprozent) des amorphen Metalls kann
aus anderen Elementen bestehen. Besonders geeignet sind
amorphe Metalle aus einer Legierung auf Co-Fe-Basis, vorzugsweise aus $Co_x Fe_y B_{100-x-y}$, mit $70 \leq x \leq 80$ und $4 \leq y \leq 10$
(x, y in Atomprozent).

Die Vorzugsrichtung der magnetischen Anisotropie wird bei-

H.Hoffmann I 1-9-5-114X-4X

Die Aufgabe wird erfindungsgemäß dadurch gelöst, daß die Sensorfläche aus einem ferromagnetischen amorphen Metall besteht. Vorteilhafte Ausgestaltungen der Erfindung sind den Unteransprüchen 2 bis 8 zu entnehmen. Die vorteilhaften Eigenschaften eines erfindungsgemäßen Magnetfeldsensors erlauben den Aufbau von Positionssensoren mit sehr feiner Auflösung. Derartige Positionssensoren sind den Ansprüchen 9 und 10 zu entnehmen.

Im folgenden wird die Erfindung anhand von Ausführungsbeispielen unter Zuhilfenahme der beiliegenden Zeichnung weiter erläutert.

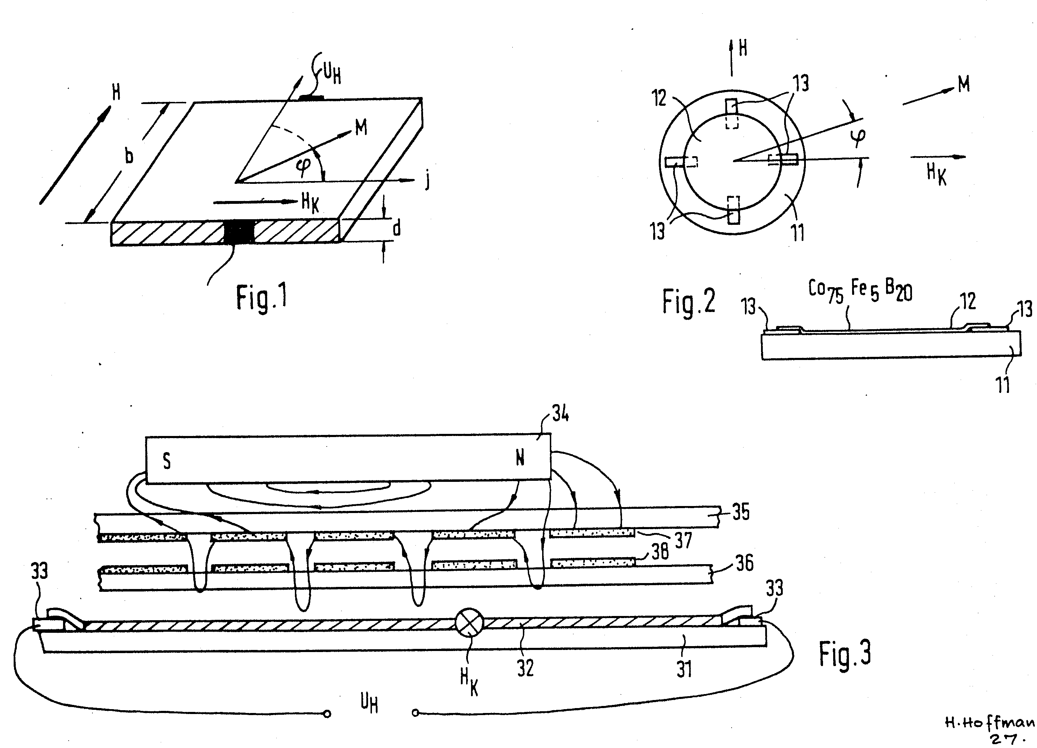

Fig. 1   zeigt eine Darstellung des planaren Halleffekts.

Fig. 2   zeigt einen erfindungsgemäß aufgebauten Magnetfeldsensor in der Aufsicht und im Schnitt.

Fig. 3   zeigt den Schnitt durch einen erfindungsgemäß aufgebauten Positionssensor mit einem Magnetfeldsensor, einem Dauermagneten und zwei gegeneinander bewegbaren Blenden.

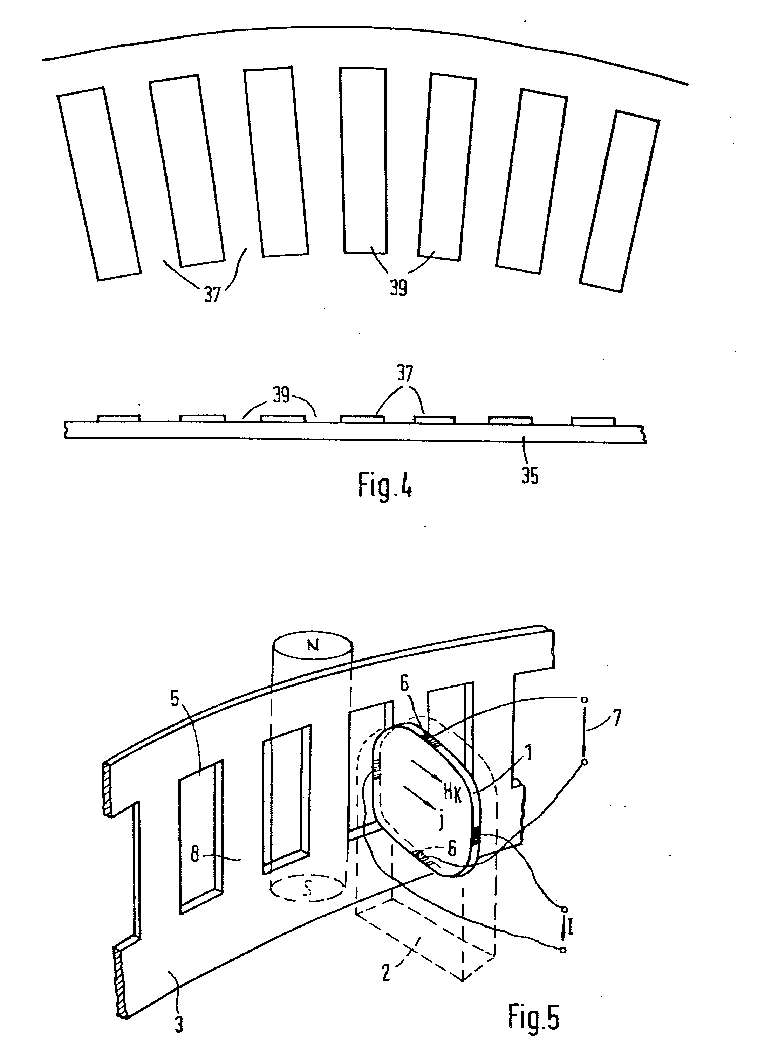

Fig. 4   zeigt einen Ausschnitt aus einer Blende für einen Positionssensor nach Fig. 3 in der Aufsicht und im Schnitt.

Fig. 5   zeigt eine perspektivische Ansicht eines erfindungsgemäßen Positionssensors mit einem Magnetfeldsensor, einem Dauermagneten und einer Blende.

H.Hoffmann I 1-9-5-114X-4X

spielsweise durch Tempern im Magnetfeld erreicht.

Anhand der Fig. 1 wird zunächst der in der Erfindung ausgenützte planare Halleffekt beschrieben. Gezeigt ist eine rechteckige Sensorfläche, beispielsweise aus einem Blech ausgestanzt oder als dünne Schicht auf ein Substrat aufgebracht, mit der Dicke d, der Breite b und beliebiger, jedoch ausreichender (siehe unten) Länge. Die Sensorfläche ist mit dem Anisotropiefeld $H_k$ in Längsrichtung vormagne-tisiert. Parallel dazu fließt, durch nicht eingezeichne-te Elektroden zu- und abgeführt, ein Strom mit der Stromdichte j. Weiter eingezeichnet ist ein äußeres, zu messen-des Magnetfeld H, das senkrecht zum Anisotropiefeld $H_k$ in der Ebene der Sensorfläche liegt. Die Magnetisierung M wird um den Winkel $\varphi$ aus der Richtung des Anisotropiefel-des $H_k$ in Richtung des äußeren Magnetfeldes H herausge-dreht. Die Richtung des Anisotropiefeldes $H_k$ wird auch als "leichte Richtung", die dazu senkrechte Richtung als "schwere Richtung" bezeichnet. Durch den planaren Hall-effekt entsteht ein elektrisches Feld, das im Idealfall homogen ist und dessen Richtung senkrecht zur Richtung des Anisotropiefeldes $H_k$ und des elektischen Stroms in der Ebene der Sensorfläche liegt. Eine aus diesem elektri-schen Feld resultierende Hallspannung $U_H$ kann an zwei einander an den Längsseiten der Sensorfläche gegenüber-liegenden Elektroden abgenommen werden.

Der durch seine Stromdichte j charakterisierte Strom I muß an zwei einander gegenüberliegenden, an den Breitsei-ten angebrachten Elektroden zu- und abgeführt werden. Reichen diese Elektroden jeweils über die ganze Breite, so wird die entstehende Hallspannung durch diese Elektro-

H.Hoffmann I 1-9-5-114X-4X

den, zumindest teilweise, kurzgeschlossen. Gehen die der Stromzuführung dienenden Elektroden nicht über die ganzen Breitseiten, so ist der Stromfluß in der Sensorfläche nicht homogen. Auch die zur Messung der Hallspannung angebrachten Elektoden und ein zu Meßzwecken an diesen Elektroden abgenommener Strom können die Messung störend beeinflussen. Der Sensor kann dann als ideal angesehen werden, wenn die Geometrie der Sensorfläche und die angebrachten Elektroden so aufeinander abgestimmt sind, daß im Bereich zwischen den beiden der Abnahme der Hallspannung dienenden Elektroden die Stromdichte j und die durch den planaren Halleffekt erzeugte elektrische Feldstärke jeweils homogen sind. Für diesen Fall gelten dann die Beziehungen

$$\varphi = \arcsin \left(\frac{H}{H_k}\right) \qquad (1)$$

$$U_H = \frac{1}{2} P \cdot j \cdot b \cdot \sin 2\varphi \qquad (2)$$

$$U_H \sim \sin\varphi \cdot \cos\varphi \cdot \frac{I}{d} \qquad (3)$$

dabei ist P die "planare Hallkonstante".

Bringt man eine solche Sensorfläche, beispielsweise eine dünne Schicht, die im Herstellungsprozeß oder einer nachfolgenden Temperaturbehandlung eine Vorzugsrichtung ("leichte Richtung", gekennzeichnet durch ein eingeprägtes Anisotropiefeld $H_k$) erhalten hat, in ein äußeres magnetisches Feld H, das senkrecht zu $H_k$ in der Ebene der Sensorfläche verläuft, so wird die Magnetisierung um den Winkel $\varphi = \arcsin \left(\frac{H}{H_k}\right)$ (Formel 1) aus der "leichten Richtung" herausgedreht.

H.Hoffmann I 1-9-5-114X-4X

An den Elektroden tritt dann eine Spannung $U_H = \frac{1}{2} P \cdot j \cdot b \cdot \sin 2\varphi$ (Formel 2) auf. Man kann die Spannung $U_H$ auch als proportional zu $\sin\varphi \cdot \cos\varphi \cdot \frac{I}{d}$ auffassen (Formel 3). Wie aus den Formeln ersichtlich ist, wird $U_H$ um so größer, je kleiner $H_k$ ist, d.h., der Sensor ist um so empfindlicher, je kleiner $H_k$ ist. Die untere Grenze für $H_k$ ist die Koerzitivfeldstärke $H_c$. Bei kristallinen Metallen sind Koerzitivfeldstärken unter ca. 100 mA/cm nicht erreichbar. Bei ferromagnetischen amorphen Metallen, insbesondere bei solchen aus einer Legierung auf Co-Fe-Basis, kann dieser Wert deutlich unterschritten werden. Diese amorphen Metalle sind deshalb besonders geeignet für die Anwendung in Magnetfeldsensoren, die den planaren Halleffekt ausnützen. Als besonders geeignet hat sich eine Legierung aus $Co_x Fe_y B_{100-x-y}$ erwiesen, mit $70 \leq x \leq 80$ und $4 \leq y \leq 10$ (x, y in Atomprozent). Versuche wurden vorzugsweise durchgeführt mit $Co_{75}Fe_5B_{20}$ und $Co_{80}B_{20}$.

Es können aber auch andere amorphe Metalle eingesetzt werden, die aus einer Legierung bestehen, die auf Übergangselementen der Eisen-Gruppe basiert. Diese Legierung kann Metalloide aus der Gruppe B, C, Si, Ge, P enthalten, ebenso wie Übergangsmetalle der Gruppe Ti, Zr, Hf, Nb. Außerdem kann bis zu fünf Prozent (Atomprozent) des amorphen Metalls aus anderen Elementen bestehen.

Anhand von Fig. 2 wird nun ein Ausführungsbeispiel näher beschrieben; die Zeichnung zeigt den erfindungsgemäßen Magnetfeldsensor in der Aufsicht und im Schnitt. Auf der Oberseite eines kreisscheibenförmigen Quarzsubstrats 11 sind zunächst vier Elektroden 13 aufgebracht. Die Elektroden 13 verlaufen im Außenbereich der Kreis-

H.Hoffmann I 1-9-5-114X-4X

scheibe in radialer Richtung und sind gegeneinander um jeweils 90° versetzt. Sie bestehen aus Gold mit einer Chrom-Haftschicht. Auf dem Quarzsubstrat 11 ist konzentrisch eine kreisförmige Sensorfläche 12 aufgebracht. Sie überdeckt teilweise die Elektroden 13. Die Sensorfläche 12 besteht aus $Co_{75}Fe_5B_{20}$ und ist als eine 100 bis 500 nm dicke Schicht im Vakuum aufgesprüht (aufgesputtert). Der Durchmesser beträgt etwa 5 bis 20 mm. Anstelle einer aufgesprühten Schicht könnte auch eine aufgedampfte Schicht Anwendung finden. Die Sensorfläche 12 weist eine magnetische Anisotropie auf, deren Vorzugsrichtung in der Sensorfläche liegt und parallel ist zur Verbindungslinie zweier einander gegenüberstehender Elektroden 13. Diese Vorzugsrichtung kann der Sensorfläche durch Tempern in einem Magnetfeld (30 Min. bei 350°C, 400 A/m) gegeben werden. Diese Vorzugsrichtung oder auch "leichte Richtung" kann durch eine Anisotropiefeldstärke $H_k$ beschrieben werden. Die gesamte Sensorfläche 12 stellt dann eine einzige magnetische Domäne dar, deren Magnetisierung parallel zur "leichten Richtung" liegt. Die magnetische Anisotropie kann im Prinzip auch schon beim Herstellungsprozeß erreicht werden, wenn sich nämlich das Quarzsubstrat 11 während des Aufstäubens oder Aufdampfens in einem entsprechenden Magnetfeld befindet. Statt aus einer dünnen Schicht kann die Sensorfläche 12 auch aus einem ausgestanzten Blechteil aus dem genannten amorphen Metall bestehen.

Zur Anwendung wird dieser Magnetfeldsensor mit den beiden einander in Richtung des Anisotropiefeldes $H_k$ gegenüberstehenden Elektroden an eine Stromquelle mit dem Strom I angeschlossen. Wird dieser stromdurchflossene Sensor in ein äußeres Magnetfeld H gebracht, dessen Richtung die

H.Hoffmann I 1-9-5-114X-4X

"schwere Richtung" (senkrecht zur "leichten Richtung") ist, so wird die Magnetisierung M in der Sensorfläche 12 um den Winkel

$$\varphi = \text{arc sin } (\frac{H}{H_k})$$

aus der "leichten Richtung" des äußeren Magnetfeldes herausgedreht. Zwischen den beiden Elektroden 13, die nicht vom Strom I durchflossen sind und die einander in Richtung der "schweren Richtung" gegenüberstehen, tritt dann die Hallspannung

$$U_H \sim \text{sin } \varphi \cdot \text{cos } \varphi \cdot \frac{I}{d}$$

auf. d ist dabei die Schichtdicke der Sensorfläche 12. Auch wenn das äußere Magnetfeld nicht in Richtung der "schweren Richtung "weist, wird die Magnetisierung M um einen genau bestimmten Winkel aus der "leichten Richtung" heraus- gedreht. Auch in diesem Fall entsteht eine Hallspannung. Durch zwei Magnetfeldsensoren kann auch in diesem Fall Größe und Richtung des Magnetfelds genau bestimmt werden. Dies ist selbst dann der Fall, wenn die "leichten Rich- tungen" dieser beiden Sensoren nicht senkrecht aufeinanderstehen. Daraus ergibt sich dann auch die Möglich- keit, beide Sensoren auf einer einzigen Sensorfläche mit geeignet verteilten Elektroden aufzubauen.

Anstelle eines Quarzsubstrats könnte auch ein solches aus Glas, Halbleiter oder Keramik verwendet werden.

H. Hoffmann I 1-9-5-114X-4X

Fig. 3 zeigt den Schnitt durch einen Positionssensor, der einen Magnetfeldsensor 31, 32, 33 und einen Dauermagneten 34, sowie zwei dazwischenliegenden Blenden 35, 37 und 36, 38 aufweist. Die Blenden bestehen jeweils aus einem Träger 35 bzw. 36, der elektrisch nicht leitet und auch nicht ferro- oder ferrimagnetisch ist und aus einer darauf aufgebrachten weichmagnetischen Schicht 37 bzw. 38, die die eigentliche Blende darstellt. Die beiden Blenden sind gegeneinander bewegbar, die weichmagnetischen Schichten weisen solche Aussparungen 39 auf, die so ausgestaltet sind, daß sie, je nach der Lage der beiden Blenden zueinander, das Magnetfeld des Dauermagneten ganz vom Sensor abschirmen oder teilweise durchlassen. Zweckmäßigerweise ist nur eine der beiden Blenden bewegbar und gibt die festzustellende Position an, die andere Blende ist unbeweglich. Der Dauermagnet ist so angeordnet, daß seine beiden Pole (senkrecht) über der Sensorfläche angeordnet sind, vorzugsweise liegt der Dauermagnet parallel zur Sensorfläche. Die magnetischen Feldlinien des Dauermagneten verlaufen dann in einer Ebene, die senkrecht auf der Sensorfläche steht. Bei "offener Blende" reichen die Magnetlinien teilweise auf die Sensorfläche durch. Der Magnetfeldsensor ist so ausgerichtet, daß die Vorzugsrichtung seiner magnetischen Anisotropie $H_k$ senkrecht zu diesen Magnetfeldlinien liegt (in Fig. 3 senkrecht zur zweiten Ebene). Die Hallspannung $U_H$ ist dann an zwei Elektroden 33 abgreifbar. Diese Elektroden 33 liegen mit den Polen des Dauermagneten etwa in einer auf der Sensorfläche senkrecht stehenden Ebene. Parallel zum Anisotropiefeld $H_k$ fließt der Strom I.

Fig. 4 zeigt eine der beiden Blenden mit ihrem Träger 35, ihrer weichmagnetischen Schicht 37 und den Aussparungen 39 ausschnittsweise im Schnitt in der Draufsicht. Die andere

H. Hoffmann I 1-9-5-114X-4X

Blende ist gleichartig aufgebaut.

Fig. 5 zeigt eine weitere erfindungsgemäße Anordnung eines Positionssensors mit einem Magnetfeldsensor, der den planaren Halleffekt ausnützt. Ein Magnetfeldsensor 1 ist in einem Träger 2 auf der einen Seite einer Blende 3 angeordnet. Auf der anderen Seite der Blende 3 ist gegenüber dem Magnetfeldsensor 1 ein Dauermagnet 4 angeordnet. Die durch die Pole des Dauermagneten 4 verlaufende Achse liegt parallel zur Blende 3. Die Blende 3 enthält Schlitze 5, die parallel zur Achse des Dauermagneten 4 verlaufen. Der Magnetfeldsensor 1 ist so angeordnet, daß seine Sensorfläche in einer Ebene liegt, die senkrecht auf der Blende 3 steht und durch die Pole des Dauermagneten 4 geht. Die Vorzugsrichtung, gekennzeichnet durch das Anisotropiefeld $H_k$, verläuft senkrecht zur Blende 3. Zwei Elektroden 6 sind so am Magnetfeldsensor 1 angeordnet, daß über sie ein Strom I fließen kann, der parallel zum Anisotropiefeld $H_k$ fließt (eine dieser Elektroden ist der Blende 3 zu-, die andere abgewandt). Zwei weitere Elektroden 6 sind oben und unten an der Sensorfläche des Magnetfeldsensors 1 angebracht; an ihnen kann die Hallspannung abgenommen werden. Das vorwiegend durch die Schlitze 5 hindurchtretende magnetische Feld des Dauermagneten dringt über die Kante des Magnetfeldsensors 1 in dessen Fläche ein. Es kann dann an den oberen und unteren Elektroden 6 die Hallspannung als Signal 7 in Form einer Spannung abgenommen werden, deren Höhe entsprechend der Folge von Schlitzen 5 und dazwischenliegenden Blechstegen 8 schwankt, wenn die Blende 3 zwischen dem Dauermagneten 4 und dem Magnetfeldsensor 1 hindurchbewegt wird.

H. Hoffmann I 1-9-5-114X-4X

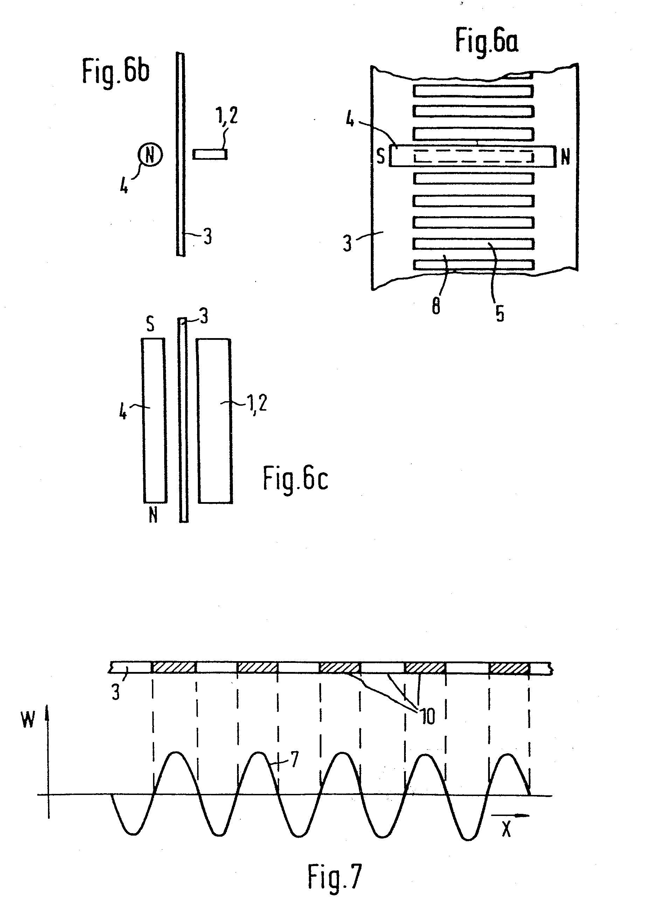

In den Figuren 6a bis c ist eine Anordnung gemäß Fig. 5 in drei verschiedenen Ansichten gezeigt. Mit N und S sind die Pole des Dauermagneten 4 bezeichnet; im übrigen sind die gleichen Bezugszeichen wie in Fig. 5 verwendet.

In Fig. 7 ist der Anteil an Wechselspannung W des Signals 7 dargestellt, welches entsprechend dem aus Schlitzen 5 und Blechstegen 8 gebildeten Raster 10 der Blende 3 örtlich abhängig von der Lage x von Dauermagnet 4 und Magnetfeldsensor 1 schwankt. Bei Bewegung der Blende entsteht demnach ein zeitlicher Signalverlauf.

In der Anordnung nach Fig. 5 liegt die Fläche des Sensors, welcher den "Planaren Halleffekt" ausnützt, in der Richtung der Linien des magnetischen Feldes. Statt eines flächigen Sensors liegt somit ein "linienförmiger" Sensor vor; statt einer magnetfeldempfindlichen Fläche liegt eine magnetfeldempfindliche Linie vor, mit der das Magnetfeld in Richtung senkrecht zum Magnetfeld und somit auch senkrecht zu dieser Linie positionsempfindlich abgetastet wird. Moduliert man das magnetische Feld mit Hilfe eines "magnetischen Strichgitters", wie z.B. der Blende 3, so kann man diese Modulation mit der Kante der dünnen Schicht des Sensors, also mit einer Linie parallel zu den Linien des Feldes, sehr lagegenau abtasten.

Eine Positionssensoranordnung findet insbesondere zur Messung der Position, Geschwindigkeit oder Beschleunigung von mechanischen Teilen in automatisch arbeitenden Geräten Verwendung.

Wenn die Position eines Gegenstandes beobachtet werden soll, kann die Änderung eines von diesem Gegenstand beeinflußten

H. Hoffmann I 1-9-5-114X-4X

magnetischen Feldes als Kriterium für seine Lage benutzt werden. Wenn der Gegenstand selbst nicht ferromagnetisch ist, ordnet man ihm eine magnetisch leitfähige Blende zu, welche sich zwischen einem Magneten und einem magnetfeldempfindlichen Sensor erstreckt. Eine solche Anordnung ist einfach, robust und an viele Verwendungsfälle leicht anzupassen. Sollen jedoch kleine Bewegungsänderungen genau registriert werden, so stößt man bei der Ausbildung solcher Anordnungen wegen der räumlichen Ausdehnung der bekannten magnetfeldempfindlichen Sensoren mit der Auflösung schnell an Grenzen. Üblicherweise werden dann optische Anordnungen eingesetzt, bei denen als Blende zwischen einer Strahlungsquelle und einem Strahlungsempfänger einfache oder doppelte, beispielsweise als Raster oder Strichgitter ausgeführte Blenden bewegt werden. Bei der optischen Abtastung eines solchen Strichgitters zur genauen Positionserfassung bzw. Erfassung der Geschwindigkeit oder Beschleunigung bewegter Teile stehen jedoch zwei Forderungen im Gegensatz zueinander, nämlich die Bewegungsauflösung (Zahl der Impulse/Weglänge) und die Empfindlichkeit der Anordnung, welche von der Helligkeit und somit von dem Durchmesser, beispielsweise eines Lichtstrahls, abhängt. Je kleiner der Durchmesser des Lichtstrahls ist, desto höher ist die Auflösung, desto geringer jedoch die erreichbare Empfindlichkeit. Ist der Strahl zu "dünn", so ist er schließlich gar nicht mehr auswertbar. Ist er dagegen "dick" genug, um sicher ausgewertet werden zu können, ist die Auflösung gering. Diese Schwierigkeit ist bei optischen Abtastsystemen dadurch behoben worden, daß ein feststehendes und ein gleichartiges, sich bewegendes Strichgitter verwendet wurde. Es kann dabei ein Bündel von Lichtstrahlen verwendet werden und es ergibt sich trotzdem eine hohe Auflösung, weil die Gesamthelligkeit von der Lage beider

H. Hoffmann I 1-9-5-114X-4X

Strichgitter zueinander abhängt. Jedoch ergibt sich dabei die neue Forderung, daß die beiden Strichgitter sehr dicht benachbart sein müssen, was oft an mechanischen Toleranzproblemen scheitert. Darüberhinaus sind derartige optische Positionssensoren um so schmutzempfindlicher, je feiner die Auflösung sein soll.

Bei einem erfindungsgemäßen Positionssensor wirft eine mögliche Verschmutzung keine Probleme auf und eine hohe Auflösung und Empfindlichkeit sind gleichermaßen erreichbar.

Bei der erfindungsgemäßen Positionssensoranordnung sind Auflösung und Empfindlichkeit vereinbare Forderungen. Je "dünner" der Sensor ist, desto höher ist seine Empfindlichkeit und seine Auflösung, wenn erfindungsgemäß der Sensor aus einer dünnen Schicht amorphen Metalls besteht und dieser derart angeordnet ist, daß die Kante der dünnen Schicht parallel zu den in der Blende in Form von Schlitzen angebrachten Öffnungen liegt und auf der der Schicht gegenüberliegenden Seite der Blende ein Dauermagnet vorhanden ist, dessen Feldlinien ebenfalls parallel zu den Schlitzen verlaufen und diese bei ausreichender Feldstärke in ausreichender Stärke durchdringen, so daß die Blechstege zwischen den Schlitzen gesättigt werden. Dann ändert sich die Feldstärke auf der anderen Seite der Blende in Abhängigkeit von den Abständen der Schlitze in Bewegungsrichtung. Hinter einem Schlitz ist die volle Feldstärke, hinter einem Blechsteg die Differenz aus voller Feldstärke und Sättigungsfeldstärke wirksam. Diese Feldstärkeschwankungen erzeugen bei bewegter Blende in dem Sensor ein Signal in Form von Spannungsschwankungen, welche schließlich mit einem Verstärker verstärkt und

H. Hoffmann I 1-9-5-114X-4X

frequenz- und phasenmäßig ausgewertet bzw. in einem Zähler gezählt werden können. Dabei weist eine Kante der dünnen Schicht aus amorphem Metall zur Blende und steht parallel zu den Schlitzen bzw. Blechstegen. Die Feldlinien treten also oben in die Kante der dünnen Schicht ein, durchlaufen diese und treten unten aus der Kante wieder aus, wobei infolge des sogenannten "Planaren Halleffektes" eine Spannung zwischen den an der oberen und unteren Kante angebrachten Elektroden entsteht.

Anstelle des Dauermagneten kann selbstverständlich auch ein Elektromagnet vorhanden sein.

H.Hoffmann I - R.Dorn - P.Kersten -
G.G.Gassmann - S.Müller 1-9-5-114X-4X

Patentansprüche

1.    Magnetfeldsensor mit einer aus einem Blech oder einer elektrisch leitenden dünnen Schicht bestehenden Sensorfläche mit magentischer Anisotropie, deren  Vorzugsrichtung in der Sensorfläche liegt, mit mindestens drei Anschlüssen,    d a d u r c h    g e k e n n z e i c h n e t, daß  die Sensorfläche aus einem ferromagnetischen amorphen Metall besteht.

2.    Magnetfeldsensor  nach Anspruch 1, dadurch gekennzeichnet, daß das amorphe Metall eine Legierung ist, die auf Übergangselementen der Eisen-Gruppe basiert.

3.    Magnetfeldsensor nach Anspruch 2, dadurch gekennzeichnet, daß das amorphe Metall Metalloide aus der Gruppe B, C, Si, Ge, P enthält.

4.    Magnetfeldsensor nach Anspruch 2 oder 3, dadurch gekennzeichnet, daß im amorphen Metall Übergangsmetalle aus der Gruppe Ti, Zr, Hf, Nb enthalten sind.

5.    Magnetfeldsensor nach einem der Ansprüche 2 bis 4, dadurch gekennzeichnet, daß bis zu fünf Prozent (Atomprozent) des amorphen Metalls aus anderen  Elementen besteht.

ZT/P2-Bs/Gn
24.06.1983

H.Hoffmann  et al 1-9-5-114X-4X

6.    Magnetfeldsensor nach Anspruch 2, dadurch gekenn-zeichnet, daß das amorphe Metall eine Legierung auf Co-Fe-Basis ist.

7.    Magnetfeldsensor nach Anspruch 3, dadurch gekenn-zeichnet, daß das amorphe Metall aus

$$Co_xFe_yB_{100-x-y}$$

besteht mit

$$70 \leq x \leq 80 \quad \text{(x in Atomprozent)}$$

und

$$4 \leq y \leq 10 \quad \text{(y in Atomprozent)}.$$

8. Magnetfeldsensor nach einem der Ansprüche 1 bis 7, dadurch gekennzeichnet, daß die Sensorfläche etwa kreisförmig oder quadratisch ist, daß zwei Anschlüsse so am Um-fang angebracht sind, daß ein über sie die Sensorfläche durchfließender Strom im wesentlichen parallel zur Vorzugsrichtung der magnetischen Anisotropie fließt und daß zwei weitere Anschlüsse so am Umfang angebracht sind, daß eine sie verbindende Gerade senkrecht auf der Vorzugsrichtung der magnetischen Anisotropie steht.

9. Positionssensor mit einem Magnetfeldsensor nach einem der Ansprüche 1 bis 8, dadurch gekennzeichnet, daß der Magnetfeldsensor so in der Nähe eines Dauermagneten angeordnet ist, daß eine die Pole des Dauermagne-ten enthaltende Ebene senkrecht auf der Sensorfläche steht, daß die Vorzugsrichtung der magnetischen Aniso-tropie des Magnetfeldsensors senkrecht zu dieser Ebene liegt, daß zwischen dem Magnetfeldsensor und dem Dauermagneten zwei gegeneinander bewegbare, eine Position angebende Blenden im wesentlichen parallel zur Sensor-

H. Hoffmann et al 1-9-5-114X-4X

fläche angeordnet sind und daß die Blenden so ausgestaltet sind, daß sie, je nach ihrer Lage zueinander, das Magnetfeld entweder ganz abschirmen oder teilweise durchlassen.

10. Positionssensor mit einem Magnetfeldsensor nach einem der Ansprüche 1 bis 8, dadurch gekennzeichnet, daß der Magnetfeldsensor so in der Nähe eines Dauermagneten angeordnet ist, daß die Sensorfläche in einer Ebene liegt, in der auch beide Pole des Dauermagneten liegen, daß die Vorzugsrichtung der magnetischen Anisotropie des Magnetfeldsensors im wesentlichen senkrecht zur Richtung der Magnetfeldlinien des Dauermagneten ausgerichtet ist und daß zwischen dem Magnetfeldsensor und dem Dauermagneten eine bewegbare, eine Position angebende Blende angeordnet ist, die Bereiche aufweist, durch die das Magnetfeld abgeschirmt wird und solche, durch die das Magnetfeld nicht abgeschirmt wird.

Fig.1

Fig.2

$Co_{75} Fe_5 B_{20}$

Fig.3

0120260

H. Hoffmann I 1-9-5-114x
27. 6. 83

Fig.4

Fig.5

H. Hoffmann I 1-9-5-114X-4X

Fig.6b

Fig.6a

Fig.6c

Fig.7